# EUROPEAN PATENT APPLICATION

(11) **EP 4 761 511 A1**
(43) Date of publication of application: **17.06.2026**
(21) Application number: 24865401.4
(22) Date of filing: 09.09.2024
(51) Int. Cl.: H10D 64/20, H10D 64/01

(54) **ELECTRONIC COMPONENT**

(30) Priority: 12.09.2023 JP 2023147519
(71) Applicant: TDK Corporation, Tokyo 103-6128 (JP)
(72) Inventor: SATO, Masato, Tokyo 103-6128 (JP); ONO, Kenta, Tokyo 103-6128 (JP); WATANABE, Takashi, Tokyo 103-6128 (JP); KITAO, Mitsuhiro, Tokyo 103-6128 (JP); TANAKA, Kosuke, Tokyo 103-6128 (JP)
(74) Representative: Epping - Hermann - Fischer
(86) International application number: PCT/JP2024/032219
(87) International publication number: WO 2025/057901

(57) **Abstract**

An electronic component includes a base material having a main surface, an insulating layer disposed on the main surface of the base material and having a step portion, a conductive layer formed on the step portion on the insulating layer, and a barrier layer covering the conductive layer, and a surface corresponding to the step portion in the conductive layer has an inclination.

## Description

### Technical Field

The present disclosure relates to an electronic component.

### Background Art

In a manufacturing process of a semiconductor or an electronic component, when covering a step portion formed on a base material, a seam (joint) may occur from the vicinity of a side wall of a step. There is a concern that an etching liquid or the like used in a subsequent process enters through the seam, causing a decrease in reliability of an element (for example, a wiring layer or a gate electrode) constituting the step portion. On the other hand, Patent Literature 1 discloses a technique in which an insulating layer covering a wiring layer is made to have a multilayer configuration to make a seam discontinuous. Further, Patent Literature 2 discloses an electronic component in which a barrier metal layer is formed on an electrode layer.

### Citation List

### Patent Literature

Patent Literature 1: International Publication WO 2017/183390
Patent Literature 2: Japanese Unexamined Publication Application 2013-80978

### Summary of Invention

### Technical Problem

However, in Patent Literature 1, generation of the seam itself cannot be suppressed, and a defect such as film formation in a state where a void (gap) is generated in an interlayer portion where a seam and a seam become discontinuous may occur. At this time, there is a possibility that seam portions are connected and a chemical, moisture, an undesired gas, or the like enters, causing a decrease in reliability. Therefore, it is required to improve reliability of an electronic component by suppressing generation of a seam and also suppressing intrusion of an etching liquid or the like.

An object of the present disclosure is to provide an electronic component capable of improving reliability.

### Solution to Problem

An electronic component according to the present disclosure includes a base material having a main surface, an insulating layer disposed on the main surface of the base material and having a step portion, a conductive layer formed on the step portion on the insulating layer, and a barrier layer covering the conductive layer, wherein a surface corresponding to the step portion in the conductive layer has an inclination.

The electronic component according to the present disclosure has the conductive layer formed on the step portion on the insulating layer. Compared to a surface on a bottom side of the step portion, a growth rate of a film of the conductive layer is slow in the step portion, so that a seam is likely to occur. On the other hand, in the present disclosure, the surface corresponding to the step portion in the conductive layer has an inclination. Thereby, continuous growth of the film of the conductive layer in the step portion is promoted, and generation of a seam can be suppressed or a seam size can be reduced. Accompanying suppression of the seam of the conductive layer, formation of a seam in the barrier layer can be suppressed. Further, since the barrier layer covers the conductive layer, even when a seam occurs in the conductive layer, intrusion of the etching liquid into the seam can be suppressed. From the above, the reliability of the electronic component can be improved.

A side surface of the barrier layer may have an inclination. For example, when an inclination is not formed on the side surface of the barrier layer, there is a possibility that a void is formed between the barrier layer and the conductive layer at a root of an electrode pad when forming the barrier layer. Then, there is a possibility that the barrier layer peels off starting from the void and the etching liquid or the like mixes into the conductive layer. On the other hand, since the inclination is formed on the side surface of the barrier layer, formation of a void is suppressed, the barrier layer becomes difficult to peel off, and an effect of preventing mixing of the etching liquid or the like is obtained more reliably.

An inclination angle of the surface corresponding to the step portion may be 110° or more and 140° or less. When the inclination angle is 110° or more, an effect of suppressing generation of a seam can be obtained. Further, by setting it to 140° or less, it is possible to suppress an excessive increase in a width of the electrode pad.

The conductive layer may contain an element other than Au. Although Au is stable against the etching liquid, presence of other elements in the conductive layer increases a concern that a formed seam is corroded and expanded by the etching liquid and reliability of the element decreases. Therefore, the effect of the present disclosure of suppressing the seam becomes more remarkable.

The base material may contain GaN. A chemical solution containing H₂O₂ is often used as the etching liquid. Since this H₂O₂ may oxidize GaN to form Ga₂O₃, when GaN is used as the base material, if the conductive layer is corroded and H₂O₂ penetrates to the base material, Ga₂O₃ is formed between GaN and the conductive layer, and there is a possibility that it will not operate as a semiconductor. Therefore, the present disclosure can make the effect more remarkable when GaN is contained in the base material.

The barrier layer may contain at least any one of Ni, Ta, Ti, W, Mo, Cr, Zn, In, Nb, Sn, and C. In this case, corrosion resistance of the barrier layer against the etching liquid can be improved. Therefore, it is possible to suppress corrosion of the conductive layer due to a defect caused by corrosion of the barrier layer.

The electronic component may further have a thin film formed on the barrier layer. In this case, even if a defect such as a hole exists in the barrier layer, the thin film can cover the defect. Therefore, corrosion of the conductive layer by the etching liquid can be more reliably suppressed.

### Advantageous Effects of Invention

According to the present disclosure, it is possible to provide an electrode pad and an electronic component capable of improving reliability.

### Brief Description of Drawings

FIG. 1 is a schematic cross-sectional view showing an electrode pad and an electronic component according to an embodiment of the present disclosure.
FIG. 2 is a schematic cross-sectional view for explaining operations and effects.
FIG. 3 is a schematic cross-sectional view showing an electrode pad and an electronic component according to a modification.
FIG. 4 is a schematic cross-sectional view showing an electrode pad and an electronic component according to a modification.
FIG. 5 is a schematic cross-sectional view showing an electrode pad and an electronic component according to a modification.
FIG. 6 is a schematic cross-sectional view showing an electrode pad and an electronic component according to a modification.
FIG. 7 is a schematic cross-sectional view showing an electrode pad and an electronic component according to a modification.
FIG. 8 is a schematic cross-sectional view showing an electrode pad and an electronic component according to a modification.
FIG. 9 is a schematic cross-sectional view showing an electrode pad and an electronic component according to a modification.

### Description of Embodiments

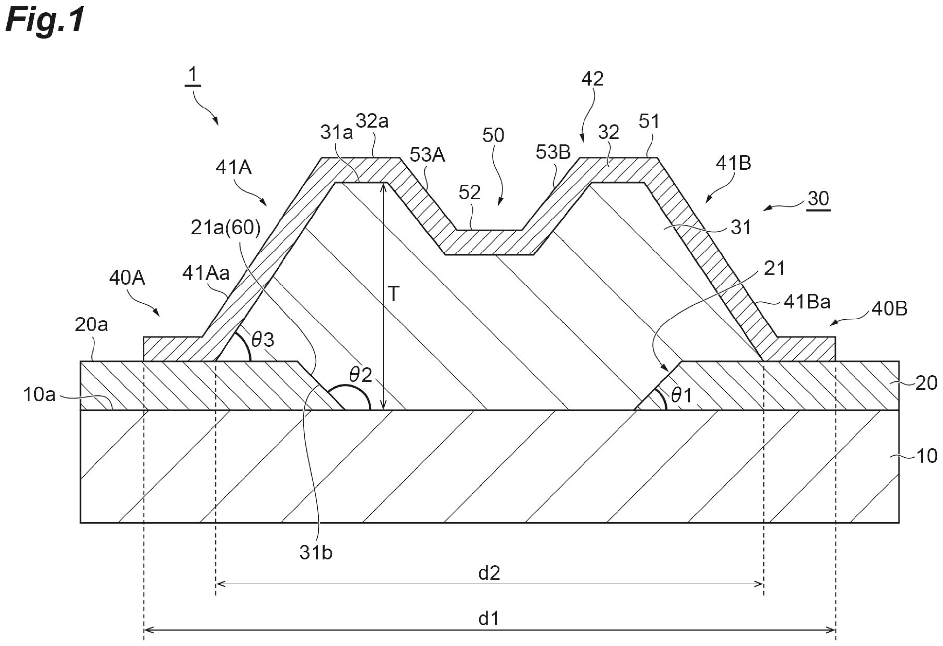

A configuration of an electrode pad and an electronic component according to an embodiment will be described with reference to FIG. 1. An electronic component 1 according to the embodiment includes a base material 10, an insulating layer 20, and an electrode pad 30. The electronic component 1 is, as an example, a semiconductor element, and is, for example, an LED element or a semiconductor laser element.

The base material 10 is a flat plate-shaped member. The base material 10 has a flat main surface 10a. The base material 10 may contain GaN. In addition, the base material 10 may contain GaAs, GaP, AlGaInP, InGaN, Si, or the like.

The insulating layer 20 is disposed on the main surface 10a so as to cover the main surface 10a of the base material 10. The insulating layer 20 is a so-called passivation film. The insulating layer 20 has a flat main surface 20a. The insulating layer 20 is composed of an oxide or a nitride containing at least one kind of element of Si, Al, Zr, Mg, Ta, Ti, and Y, or a resin. For example, the insulating layer 20 may contain at least one of silicon oxide, silicon nitride, silicon oxynitride, epoxy resin, and polyimide. A thickness of the insulating layer 20 is not particularly limited, but may be 100 nm or more and may be 3000 nm or less.

An opening 21 is provided in the insulating layer 20. The opening 21 has an arbitrary shape (for example, a circular shape, a polygonal shape, etc.) when viewed from a direction orthogonal to the main surface 10a. The opening 21 of the insulating layer 20 has an inner peripheral surface 21a extending in a vertical direction between the main surface 10a of the base material 10 and the main surface 20a of the insulating layer 20. In the present embodiment, the inner peripheral surface 21a is inclined with respect to the main surface 10a. Details of a configuration of the inner peripheral surface 21a will be described later.

The electrode pad 30 is composed of a metal material. The electrode pad 30 is an electrode provided in the vicinity of the opening 21 of the insulating layer 20 and extending in a normal direction of the main surface of the base material 10. The electrode pad 30 includes a conductive layer 31 and a barrier layer 32. The conductive layer 31 is a portion located on an upper side of the insulating layer 20. The electrode pad 30 has an arbitrary shape (for example, a circular shape, a polygonal shape, etc.) when viewed from the direction orthogonal to the main surface 10a.

The conductive layer 31 is formed in the opening 21 so as to cover the opening 21 of the insulating layer 20. The conductive layer contains an element other than Au. The conductive layer 31 can be formed by, for example, sputtering or vacuum deposition of Cu. More specifically, the conductive layer 31 integrally covers an edge of the opening 21 in the main surface 20a of the insulating layer 20, the main surface 10a of the base material 10 exposed from the opening 21, and the inner peripheral surface 21a of the opening 21.

The barrier layer 32 is a layer covering the conductive layer 31. The barrier layer 32 covers the entire area of an outer surface 31a of the conductive layer 31. As described above, the conductive layer 31 covers the edge of the opening 21 of the insulating layer 20. Therefore, the barrier layer 32 also covers the edge of the opening 21 of the insulating layer 20. Therefore, the barrier layer 32 extends onto the insulating layer 20. The barrier layer 32 may contain any one or two of Ni, Ta, Ti, W, Mo, Cr, Zn, In, Nb, Sn, and C. A thickness of the barrier layer 32 may be 100 nm or more, and may be 300 nm or more. The thickness of the barrier layer 32 may be 3000 nm or less, and may be 1000 nm or less. The barrier layer 32 is not particularly limited, but may be formed by plating or the like.

Next, a cross-sectional shape of the electronic component 1 will be described. The inner peripheral surface 21a of the opening 21 becomes a step portion 60 between the main surface 10a of the base material 10 and the main surface 20a of the insulating layer 20. The inner peripheral surface 21a of the opening 21, that is, the step portion 60 is inclined with respect to the main surface 10a of the base material 10. The step portion 60 is inclined so as to go toward an outer peripheral side as it goes from the main surface 10a of the base material 10 toward the main surface 20a of the insulating layer 20. A cross-sectional shape of the step portion 60 is inclined so as to draw a straight line. However, the shape of the step portion 60 does not have to be a straight line and may be a curved line. An inclination angle θ1 of the step portion 60 may be 40° or more and may be 50° or more. Further, the inclination angle θ1 may be 70° or less and may be 60° or less. The inclination angle θ1 is an angle with respect to the main surface 10a.

The conductive layer 31 covers the exposed main surface 10a, the inclined step portion 60, and the main surface 20a of the insulating layer 20 in the opening 21. Therefore, in the conductive layer 31, a surface 31b corresponding to the step portion 60 of the opening 21 has an inclination. An inclination angle θ2 of the outer surface 31a may be 110° or more and may be 120° or more. Further, the inclination angle θ2 may be 140° or less and may be 130° or less. The inclination angle θ2 is an angle with respect to the main surface 10a.

The electrode pad 30 has a shape rising upward from the base material 10. The electrode pad 30 has edge portions 40A and 40B, rising portions 41A and 41B, and a body portion 42. The rising portion 41 is a portion rising upward from the insulating layer 20. The body portion 42 is a portion formed thick at a central position of the electrode pad 30. A thickness T of the conductive layer 31 in the body portion 42 may be 100 nm or more and may be 5000 nm or less.

In the present embodiment, the outer surface 31a of the conductive layer 31 and the outer surface 32a of the barrier layer 32 have shapes having the same purport as each other, and are in a substantially parallel relationship. The outer surface of the electrode pad 30 corresponds to the outer surface 32a of the barrier layer 32 which is an outermost layer.

In a cross-sectional view, the body portion 42 has a pair of edge portions 40A and 40B and a pair of rising portions 41A and 41B on left and right sides. The edge portions 40A and 40B are provided on the main surface 20a of the insulating layer 20. The edge portions 40Aand 40B are formed by the barrier layer 32 further extending toward the outer peripheral side from an end portion on the outer peripheral side of the conductive layer 31. Thereby, the vicinity of the end portion on the outer peripheral side of the conductive layer 31 is completely covered with the barrier layer 32. Note that the barrier layer 32 needs to have a length such that it does not contact another adjacent electrode pad 30. When a width dimension of the barrier layer 32 is defined as "d1" and a width dimension of the conductive layer 31 is defined as "d2", a relationship of "d2/d1 ≤ 0.98" may be established. Furthermore, if "d2/d1 ≤ 0.96", intrusion of the etching liquid can be more prevented, and if "d2/d1 ≤ 0.90", intrusion of the etching liquid can be prevented more reliably.

The rising portions 41A and 41B are inclined with respect to the main surface 20a of the insulating layer 20. Therefore, in the barrier layer 32, side surfaces 41Aa and 41Ba corresponding to the rising portions 41A and 41B have an inclination. These side surfaces 41Aa and 41Ba become side surfaces of the electrode pad 30. Cross-sectional shapes of the side surfaces 41Aa and 41Ba are inclined so as to draw a straight line. However, shapes of the side surfaces 41Aa and 41Ba do not have to be straight lines and may be curved lines. An inclination angle θ3 of the side surfaces 41Aa and 41Ba may be 45° or more and 80° or less.

The outer surfaces 31a and 32a of the body portion 42 extend along a direction in which the main surface 10a extends, between an upper end of the rising portion 41A and an upper end of the rising portion 41B. A recess 50 is formed at a central position of the outer surfaces 31a and 32a of the body portion 42. The recess 50 has a bottom surface 52 disposed at a position lower than an upper surface 51 of the body portion 42, and a pair of side surfaces 53A and 53B extending from the bottom surface 52 to the upper surface 51.

As described above, a method of providing an inclination in the step portion 60 will be described. For example, a resist in which an opening is formed is heat-treated (post-baked) as in Japanese Patent No. 4361415 to incline the resist. Further, by performing an anisotropic etching process such as reactive ion etching (RIE) on it, the step portion 60 formed in the insulating layer 20 can be inclined. Furthermore, a mixing ratio of a process gas used in reactive ion etching (for example, a mixed gas of CHF₃ and O₂ is used when etching thermal silicon oxide) is changed. Thereby, a selection ratio with respect to the resist can be controlled, and the inclination angle of the step portion 60 can be finely adjusted.

Operations and effects of the electronic component 1 according to the present embodiment will be described.

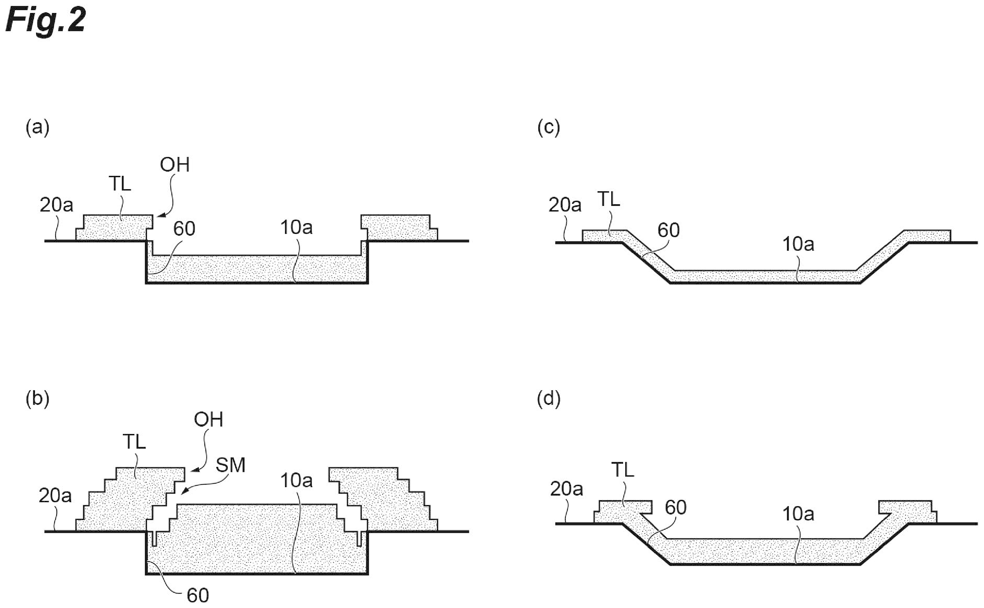

The electrode pad 30 is formed on the step portion 60 in the insulating layer 20 on the base material 10. For example, as a comparative example, a structure in which the step portion 60 is perpendicular to the main surface 10a is cited. In this case, as shown in (a) and (b) parts of FIG. 2, a growth rate of the film of the conductive layer 31 is slow in the step portion 60 compared to the main surface 10a on the bottom side of the step portion 60, so that a seam is likely to occur. As shown in (a) part of FIG. 2, when laminating a film TL for constituting the conductive layer 31, if growth of the film TL with respect to the step portion 60 is slow, an overhang OH (eaves) is formed on an upper part of the step portion 60 where growth is fast. If the film TL is laminated as it is, growth of the film TL at the step portion 60 becomes further slower due to being in a shadow of the overhang OH. As a result, as shown in (b) part of FIG. 2, a seam SM occurs.

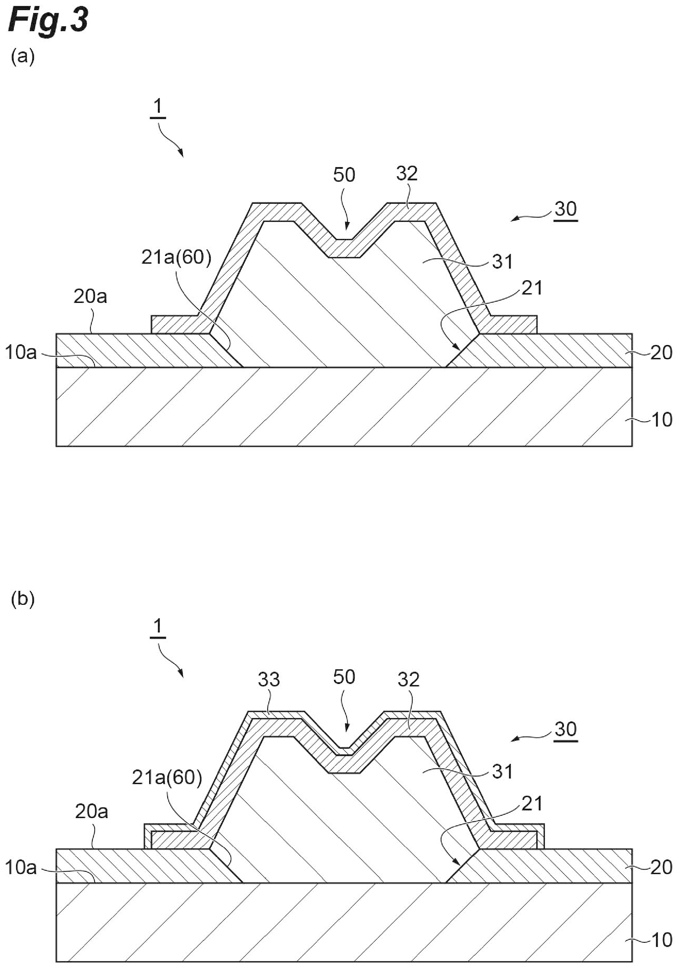

On the other hand, in the present embodiment, the surface 31b corresponding to the step portion 60 in the conductive layer 31 has an inclination. Thereby, continuous growth of the film of the conductive layer 31 in the step portion 60 is promoted, and generation of a seam can be suppressed or a seam size can be reduced. For example, as shown in (c) part of FIG. 2, since the step portion 60 has an inclination, a growth rate of the film TL can be improved. As a result, as shown in (d) part of FIG. 2, even if there is an overhang OH, an influence on growth of the film TL at the step portion 60 can be reduced. Accompanying suppression of the seam of the conductive layer 31, formation of a seam in the barrier layer 32 can be suppressed. Further, since the barrier layer 32 covers the conductive layer 31, even when a seam occurs in the conductive layer 31, intrusion of the etching liquid into the seam can be suppressed. Note that when a thin film 33 as shown in (b) part of FIG. 3 is further formed, intrusion of the etching liquid can be suppressed. From the above, the reliability of the electronic component 1 can be improved.

The side surfaces 41Aa and 41Ba of the barrier layer 32 may have an inclination. For example, when an inclination is not formed on the side surfaces 41Aa and 41Ba of the barrier layer 32, there is a possibility that a void is formed between the barrier layer 32 and the conductive layer 31 at a root of the electrode pad 30 when forming the barrier layer 32. Then, there is a possibility that the barrier layer 32 peels off starting from the void and the etching liquid or the like mixes into the conductive layer 31. On the other hand, since the inclination is formed on the side surfaces 41Aa and 41Ba of the barrier layer 32, formation of a void is suppressed, the barrier layer 32 becomes difficult to peel off, and an effect of preventing mixing of the etching liquid or the like is obtained more reliably.

The inclination angle θ2 of the surface 31b corresponding to the step portion 60 may be 110° or more and 140° or less. When the inclination angle θ2 is 110° or more, an effect of suppressing generation of a seam can be obtained. Further, by setting it to 140° or less, it is possible to suppress an excessive increase in a width of the electrode pad 30.

The conductive layer 31 may contain an element other than Au. Although Au is stable against the etching liquid, presence of other elements in the conductive layer 31 increases a concern that a formed seam is corroded and expanded by the etching liquid and reliability of the element decreases. Therefore, the effect of the present disclosure of suppressing the seam becomes more remarkable.

The base material 10 may contain GaN. A chemical solution containing H₂O₂ is often used as the etching liquid. Since this H₂O₂ may oxidize GaN to form Ga₂O₃, when GaN is used as the base material, if the conductive layer is corroded and H₂O₂ penetrates to the base material, Ga₂O₃ is formed between GaN and the conductive layer, and there is a possibility that it will not operate as a semiconductor. Therefore, the present disclosure can make the effect more remarkable when GaN is contained in the base material.

The barrier layer 32 may contain at least any one of Ni, Ta, Ti, W, Mo, Cr, Zn, In, Nb, Sn, and C. In this case, corrosion resistance of the barrier layer 32 against the etching liquid can be improved. Therefore, it is possible to suppress corrosion of the conductive layer 31 due to a defect caused by corrosion of the barrier layer 32.

The present disclosure is not limited to the above-described embodiment.

For example, as shown in (a) part of FIG. 3, the width of the electrode pad 30 may be smaller as a whole compared to the structure of FIG. 1. In this case, a width of the recess 50 may be small. Further, a structure in which the conductive layer 31 does not run onto the main surface 20a of the insulating layer 20 may be adopted. Such a structure can be configured by narrowing an opening of a resist during manufacturing.

Further, like the electronic component 1 shown in (b) part of FIG. 3, it may further have a thin film 33 formed on the barrier layer 32. The thin film 33 covers the barrier layer 32 over the whole. A material of the thin film 33 is not particularly limited, but for example, Au, Sn, Pd, or the like may be adopted. A thickness of the thin film 33 is not particularly limited, but may be 10 nm or more and 300 nm or less. In this case, even if a defect such as a hole exists in the barrier layer 32, the thin film 33 can cover the defect. Therefore, corrosion of the conductive layer 31 by the etching liquid can be more reliably suppressed. Note that the thin film 33 may be applied to the electronic component 1 shown in other figures.

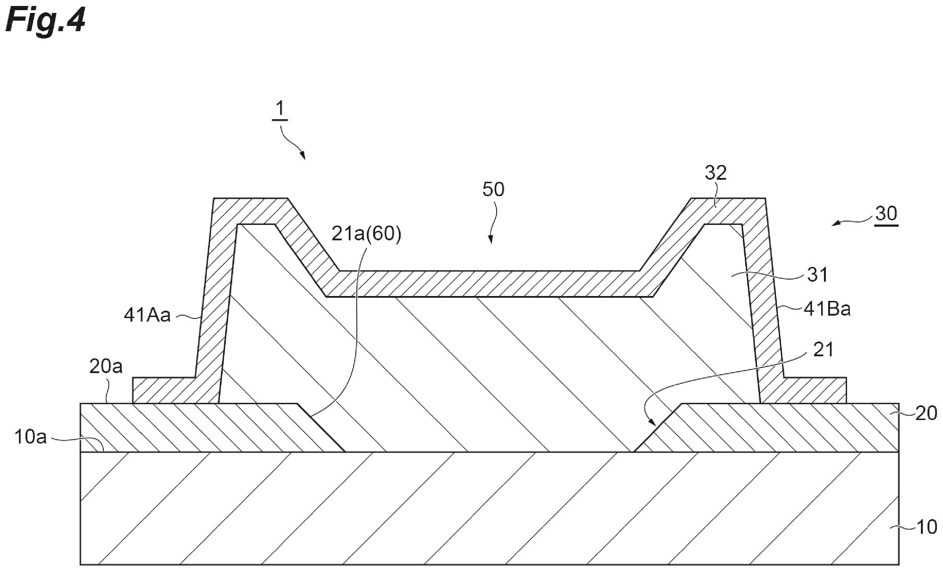

For example, as shown in FIG. 4, the width of the recess 50 may be larger compared to the structure of FIG. 1. Further, the side surfaces 41Aa and 41Ba of the electrode pad 30 may be inclined at an angle close to vertical. Such a structure can be configured by lowering a pressure of a gas atmosphere to increase straightness of particles when forming a film by sputtering or the like.

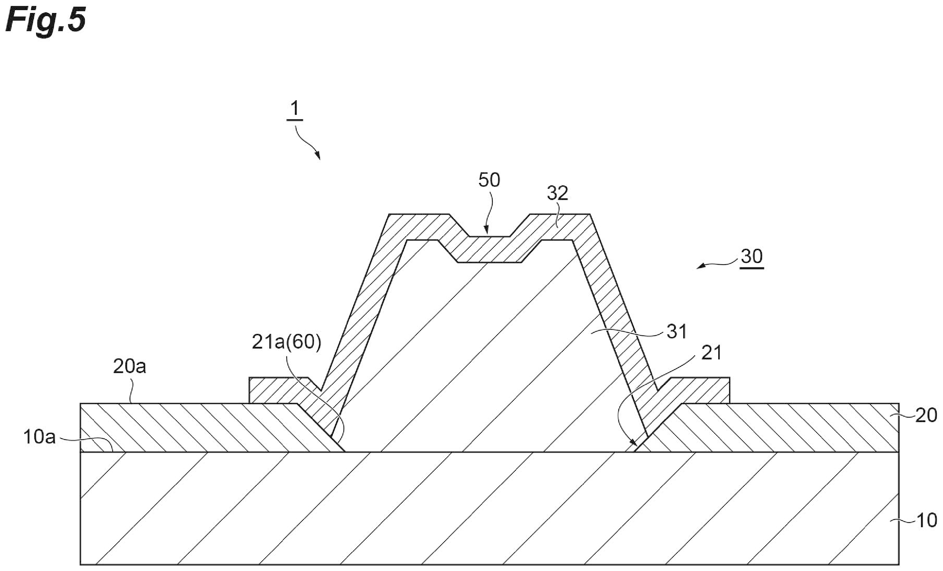

For example, as shown in FIG. 5, the end portion on the outer peripheral side of the conductive layer 31 may be disposed on the step portion 60. In this case, the barrier layer 32 has a structure of sinking into a gap between the conductive layer 31 and the step portion 60. Note that since an amount by which the electrode pad 30 runs onto the step portion 60 is small, a depth of the recess 50 also becomes shallow. Such a structure can be configured by narrowing an opening of a resist during manufacturing.

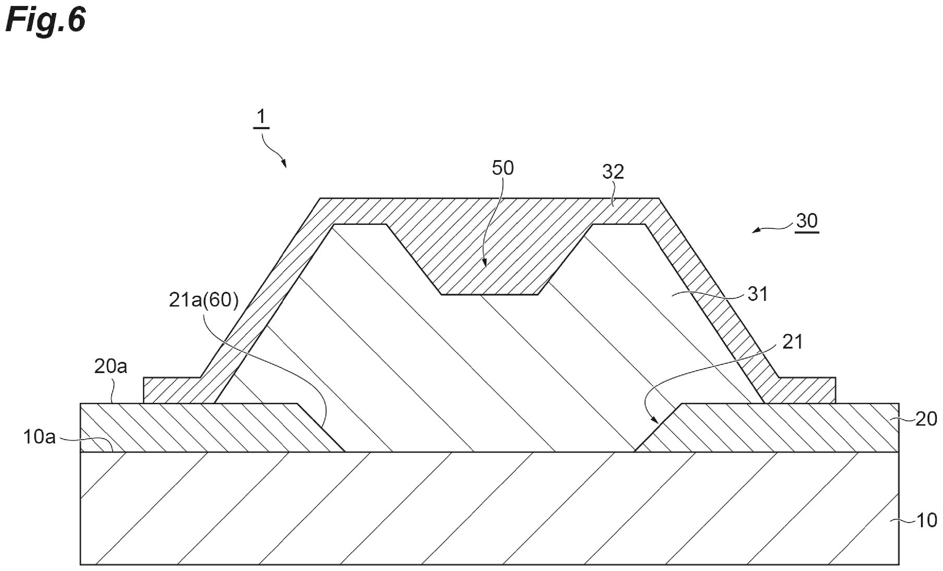

For example, as shown in FIG. 6, a structure in which the recess 50 is filled with the barrier layer 32 may be adopted. Such a structure can be configured by using resists having different diameters multiple times and forming the barrier layer 32 in multiple steps.

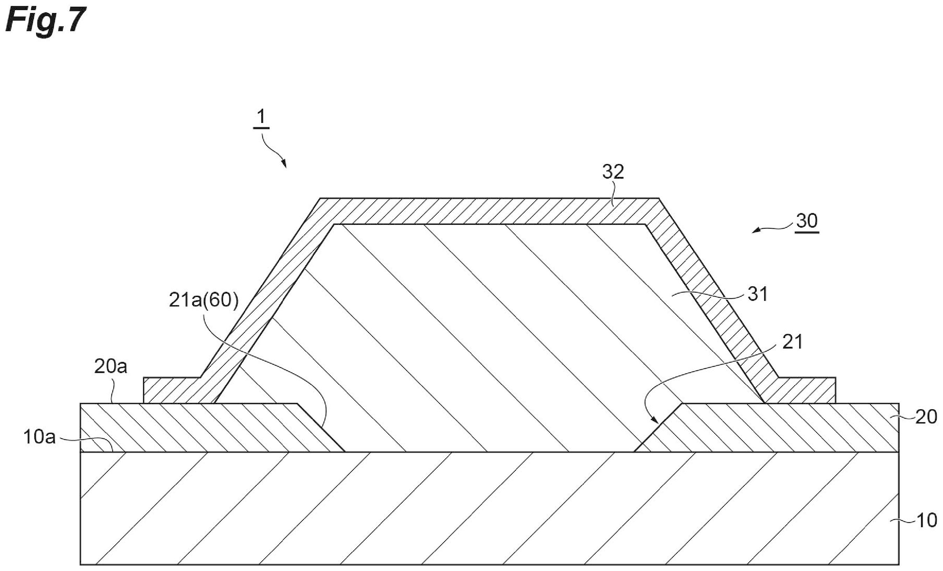

For example, as shown in FIG. 7, an upper surface of the electrode pad 30 may be made flat so that the recess 50 is not formed. Such a structure can be configured by using resists having different diameters multiple times and forming the conductive layer 31 in multiple steps.

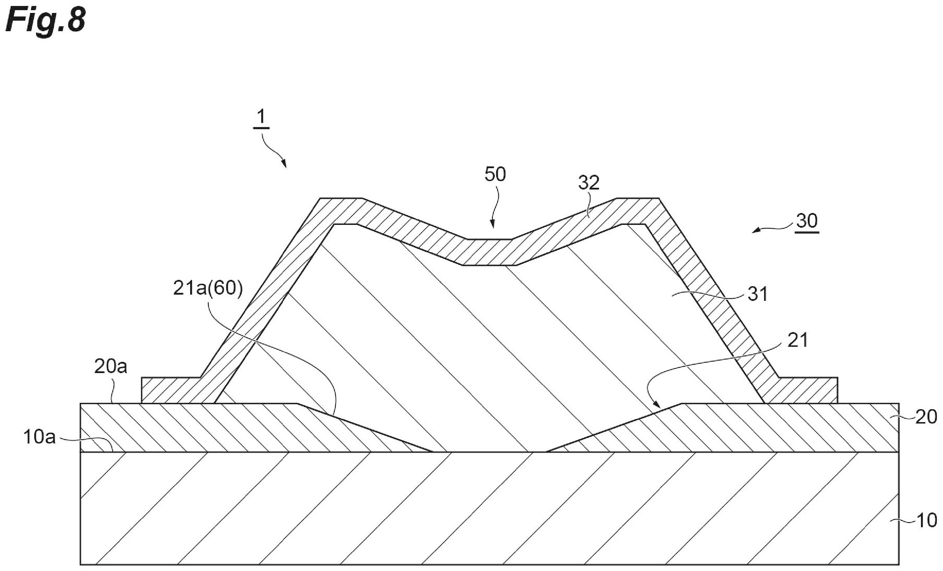

For example, as shown in FIG. 8, compared to FIG. 1, the recess 50 may be configured to be shallow. Such a structure can be configured by reducing the inclination of the step portion 60.

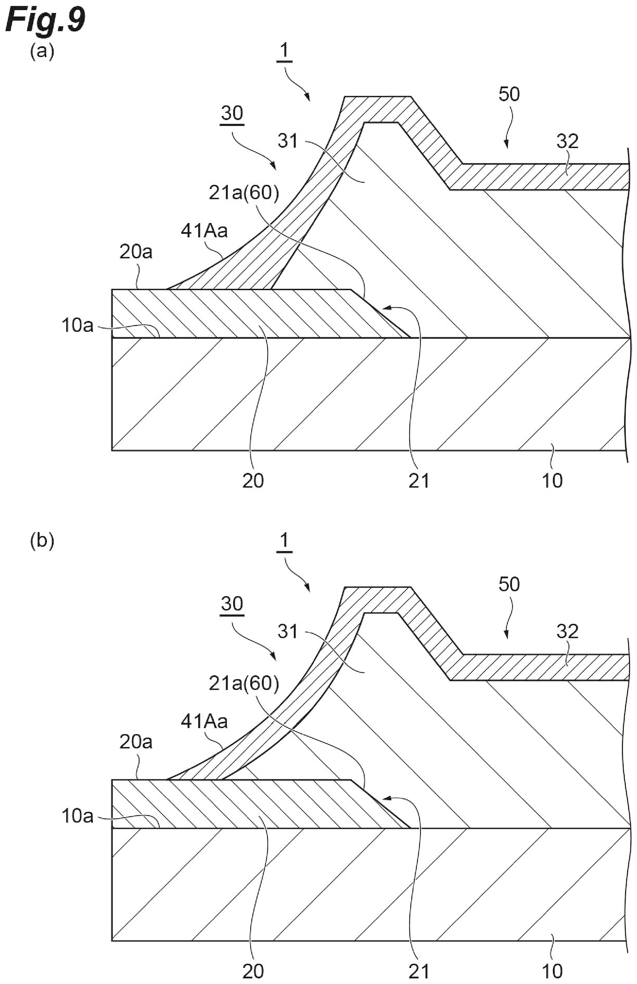

For example, as shown in (a) part of FIG. 9, a configuration in which an end portion of the barrier layer 32 gradually becomes thinner as it goes upward may be adopted. By having such a shape, a step formed on the barrier layer 32 itself becomes small. Therefore, since application of stress to the step of the barrier layer 32 can be suppressed, the barrier layer 32 becomes more difficult to peel off. Thereby, intrusion of the etching liquid can be prevented more reliably.

As shown in (b) part of FIG. 9, an end portion of the conductive layer 31 may also have a gradually gentler inclination as it goes upward. By having such a shape, an angle change at a boundary between a terminal of the conductive layer 31 and the insulating layer 20 becomes gentle, and the barrier layer 32 existing on the boundary becomes difficult to peel off. Therefore, intrusion of the etching liquid can be prevented more reliably.
[Aspect 1] An electronic component comprising: a base material having a main surface; an insulating layer disposed on the main surface of the base material and having a step portion; a conductive layer formed on the step portion on the insulating layer; and a barrier layer covering the conductive layer, wherein a surface corresponding to the step portion in the conductive layer has an inclination.
[Aspect 2] The electronic component according to Aspect 1, wherein a side surface of the barrier layer has an inclination.
[Aspect 3] The electronic component according to Aspect 1 or 2, wherein an inclination angle of the surface corresponding to the step portion is 110° or more and 140° or less.
[Aspect 4] The electronic component according to any one of Aspects 1 to 3, wherein the conductive layer contains an element other than Au.
[Aspect 5] The electronic component according to any one of Aspects 1 to 4, wherein the base material contains GaN.
[Aspect 6] The electronic component according to any one of Aspects 1 to 5, wherein the barrier layer contains at least any one of Ni, Ta, Ti, W, Mo, Cr, Zn, In, Nb, Sn, and C.
[Aspect 7] The electronic component according to any one of Aspects 1 to 6, further comprising a thin film formed on the barrier layer.

### Reference Signs List

- 1: electronic component
- 10: base material
- 20: insulating layer
- 30: electrode pad
- 31: conductive layer
- 32: barrier layer
- 41Aa, 41Ba: side surface
- 60: step portion

## Claims

1. An electronic component comprising:
a base material having a main surface;
an insulating layer disposed on the main surface of the base material and having a step portion; a conductive layer formed on the step portion on the insulating layer; and
a barrier layer covering the conductive layer,
wherein a surface corresponding to the step portion in the conductive layer has an inclination.

2. The electronic component according to Claim 1, wherein a side surface of the barrier layer has an inclination.

3. The electronic component according to Claim 1, wherein an inclination angle of the surface corresponding to the step portion is 110° or more and 140° or less.

4. The electronic component according to Claim 1, wherein the conductive layer contains an element other than Au.

5. The electronic component according to Claim 1, wherein the base material contains GaN.

6. The electronic component according to Claim 1, wherein the barrier layer contains at least any one of Ni, Ta, Ti, W, Mo, Cr, Zn, In, Nb, Sn, and C.

7. The electronic component according to Claim 1, further comprising a thin film formed on the barrier layer.
